Europäisches Patentamt

European Patent Office

Office européen des brevets

(19)

(11) EP 1 365 263 A1

(12) EUROPEAN PATENT APPLICATION

(43) Date of publication:
26.11.2003 Bulletin 2003/48

(51) Int Cl.$^7$: G02B 5/08, G02B 1/10

(21) Application number: 03252971.1

(22) Date of filing: 13.05.2003

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 17.05.2002 JP 2002142454

(71) Applicant: CANON KABUSHIKI KAISHA
Tokyo (JP)

(72) Inventors:
• Masaki, Fumitaro, c/o Canon Kabushiki Kaisha
Tokyo (JP)
• Miyake, Akira
Tokyo (JP)

(74) Representative:
Beresford, Keith Denis Lewis et al
BERESFORD & Co.
2-5 Warwick Court,
High Holborn
London WC1R 5DH (GB)

(54) **Optical element, and light source unit and exposure apparatus having the same**

(57)    An optical element includes plural multilayer mirrors, and is characterised in that the multilayer mirrors are renewable.

The multilayer mirrors may comprise a substrate, a release layer and reflection multilayers, in which the release layer is much more soluble than the substrate. Alternatively, the reflection multilayers may be more soluble or more easily removed e.g. by reactive ion etching than the substrate or an intervening buffer layer. The reflection multilayers are removable so that the substrate can be recoated e.g. if the multilayers have been damaged by debris. The optical element may be used for reflecting extreme ultraviolet light in exposure apparatus for semiconductor device fabrication.

<u>100</u>

FIG.3

EP 1 365 263 A1

Printed by Jouve, 75001 PARIS (FR)

**Description**

The present invention relates generally to optical elements, and more particularly to a renewable optical element that may be reused after it deteriorates.

Along with recent demands on smaller and lower profile electronic devices, fine semiconductor devices to be mounted onto these electronic devices have been increasingly demanded. For example, a design rule for a mask pattern requires an extensive formation of the image with a size of a line and space ("L & S") of 0.1 μm or less, which will predictably shift to a formation of circuit patterns of 80 nm or less in the future. L & S denotes an image projected onto a wafer in exposure with equal line and space widths, and serves as an index of exposure resolution.

A projection exposure apparatus as a typical exposure apparatus for fabricating semiconductor devices, generally has an illumination apparatus that includes a light source such as laser and an illumination optical system for illuminating a reticle (mask), and a projection optical system that is located between the mask and an object to be exposed. Recent years have required smaller resolution to transfer a finer circuit pattern, and attempted to improve the resolution using a shorter wavelength. An exposure light source has recently been shifted from KrF excimer laser (with a wavelength of approximately 248 nm) and ArF excimer laser (with a wavelength of approximately 193 nm) to $F_2$ excimer laser (with a wavelength of approximately 157 nm). Practical use of extreme ultraviolet ("EUV") light with a wavelength of 5 to 20 nm has also been promoted. When the EUV light is used as exposure light, no transmission and refraction-type materials are usable, and optical systems need to include only reflection-type or catoptric optical elements, *i.e.*, mirrors. The catoptric optical element in an exposure apparatus using EUV light includes a grazing-incidence total-reflection mirror and a multilayer mirror.

A real part of the refractive index is slightly smaller than 1 in the EUV region, and generates total reflection for EUV light enters a surface with a narrow grazing angle. A grazing-incidence total-reflection mirror may usually maintain its reflectance higher than several scores of percentage for obliquely incident light within several degrees from the surface, but its degree of freedom in design is small.

A multilayer mirror that alternately forms or layers two kinds of materials having different optical constants is used for a mirror for EUV light with an incident angle close to normal incidence. The multilayer mirror reflects EUV light with a specific wavelength when receiving EUV light. The wavelength λ of the reflected EUV light is approximately expressed by Bragg's equation below where θ is an incident angle and d is a coating cycle:

$$2 \cdot d \cdot \cos\theta = \lambda \qquad (1)$$

Efficiently reflected EUV light is one within a narrow bandwidth around λ that satisfies the equation 1, and the bandwidth is about 0.6 to 1 nm.

For example, a condenser mirror as a first mirror for efficiently taking in EUV light emitted isotropically from a light source (a plasma) is made of a spheroid or paraboloid of revolution with a concave curvature viewed from the light source (the plasma). A sufficiently smooth substrate is necessary to avoid lowered reflectance, and a relationship between reflectance R and surface roughness σ of the substrate is given by the equation below by using the wavelength λ, the incident angle θ, and reflectance $R_o$ without surface roughness:

$$R = R_o \exp [- (4\pi\sigma\cdot\cos\theta/\lambda)^2] \qquad (2)$$

When the light with a wavelength of 13 nm enters a multilayer mirror with normal incidence or at an angle θ of 0° and the degradation of reflectance due to the surface roughness is within 5 % or less, Equation 2 requires the surface roughness σ = 0.2 nm. Thus, the substrate needs a precisely polished curved surface.

A multilayer is formed on this substrate. Evaporation is a major coating method that evaporates several types of materials, rotates a holder that supports the substrate, and passes it over an evaporation source. The evaporation has a difficulty in uniformly coating as the substrate's offset from a flat surface or curvature becomes large. In addition, the EUV light incident upon the first mirror has different incident angles depending upon locations, and requires a thickness distribution. Disadvantageously, a fabrication of a multilayer mirror with a large curvature is very difficult.

Debris is a critical problem for an EUV light source. The debris is particles scattering from the light source. A debris source depends upon a light source system. For example, a target or a supply nozzle is an emission source for a laser plasma light source. Debris disadvantageously sticks to a multilayer or collides with the multilayer, destroying its multilayer structure and lowering its reflectance. Of course, the mirror reflectance lowers due to deteriorations with time, and contamination by impurities inside a vacuum chamber.

A deteriorated mirror should be exchanged so as to always ensure adequate reflectance for exposure with high exposure performance such as throughput. The first mirror in particular is easily subject to debris and deterioration. As discussed, a multilayer mirror is complicated and difficult to fabricate, and a precisely polished substrate is often expensive. Therefore, an exchange of a deteriorated multilayer mirror with a new multilayer mirror is not preferable because an exposure apparatus user incurs increased running cost for an apparatus and thus large economical burden.

Accordingly, an embodiment of the present invention seeks to easily form a multilayer mirror with a large curvature, and to provide an optical element whose deteriorated mirror is made reusable, and a light source unit and an exposure apparatus having the same.

An optical element of one aspect of the present invention includes plural multilayer mirrors, wherein the multilayer mirrors are renewable. The optical element may have a concave shape, and serves to condense incident light. The multilayer mirror may have a dividable side along a line having an equal incident light angle to the optical element.

The multilayer mirror may form a release layer and a multilayer in this order on a substrate, and the release layer may be soluble in a solution that is less reactive with the substrate. The release layer may dissolve in the solution at a speed 1000 times or more than the substrate.

The multilayer mirror may form a buffer layer and a multilayer in this order on a substrate, and the multilayer may be soluble in etchant that is less reactive with the buffer layer. The buffer layer may dissolve in the etchant at a speed equal to or less than 1/1000 of a solution velocity of the multilayer.

The multilayer mirror may form a buffer layer and a multilayer in this order on a substrate, and the multilayer may be removable by a dry etching process that is less reactive with the buffer layer. The buffer layer may be removed by the dry etching process at a speed equal to or less than 1/1000 of a removal velocity of the multilayer.

The multilayer mirror may form a buffer layer, a release layer, and a multilayer in this order on a substrate, and the release layer may be soluble in a solution that is less reactive with the buffer layer. The release layer may dissolve in the solution at a speed 1000 times or more than that of the buffer layer.

The multilayer mirror is designed to reflect EUV light (with a wavelength of 5 to 20 nm). It may have a protective layer for protecting the multilayer mirror on its surface.

A light source unit of another aspect of the present invention includes a light source that generates light, and the above optical element that includes plural multilayer mirrors, and condenses the light generated from the light source, wherein the multilayer mirror is renewable. The light may be EUV light (with a wavelength of 5 to 20 nm).

An exposure apparatus of another aspect of the present invention includes the above optical element for introducing light from a light source to an object to be exposed. The exposure apparatus may further include an illumination optical system that includes the optical element at a first stage, the illumination optical system using light that has passed the optical element to illuminate a reticle (mask), and a projection optical system for projecting a pattern formed on the reticle onto the object. The light may be EUV light (with a wavelength of 5 to 20 nm).

An exposure apparatus of still another aspect of the present invention includes the above light source, an illumination optical system that uses light from the light source unit to illuminate a reticle (mask), and a projection optical system for projecting a pattern formed on the reticle onto an object to be exposed.

A device fabrication method of another aspect of this invention includes the steps of exposing a plate by using the above exposure apparatus, and performing a predetermined process for the exposed object. Claims for a device fabrication method for performing operations similar to that of the above exposure apparatus cover devices as intermediate and final products. Such devices include semiconductor chips like an LSI and VLSI, CCDs, LCDs, magnetic sensors, thin film magnetic heads, and the like.

Embodiments of the present invention will now be described with reference to the accompanying drawings.

FIG. 1 is a typical view showing an exposure apparatus of one aspect of the present invention.

FIG. 2 is an enlarged typical view around an EUV light source shown in FIG. 1.

FIG. 3 is a schematic sectional view showing one mirror in an optical element shown in FIG. 2.

FIG. 4 is a schematic typical view showing an evaporation apparatus.

FIG. 5 is a typical view showing a subdivision of the optical element shown in FIG. 2.

FIG. 6 is a typical view showing an example of an optical element.

FIG. 7 is a view showing an offset of a divided multilayer mirror from a flat surface.

FIG. 8 is a sectional view showing an optical element as a variation of the optical element, which corresponds to FIG. 3.

FIG. 9 is a sectional figure showing an optical element as a variation of the optical element, which corresponds to FIG. 3.

FIG. 10 is a sectional figure showing an optical element as a variation of the optical element, which corresponds to FIG. 3.

FIG. 11 is a sectional figure showing an optical element as a variation of the optical element, which corresponds to FIG. 3.

FIG. 12 is a graph showing spectral transmittance of polypropylene of 0.1 μm.

FIG. 13 is a graph showing an attenuation length of polypropylene.

FIG. 14 is a flowchart for explaining how to fabricate devices (such as semiconductor chips such as ICs and LCDs, CCDs, and the like).

FIG. 15 is a detail flowchart of a wafer process as Step 4 shown in FIG. 14.

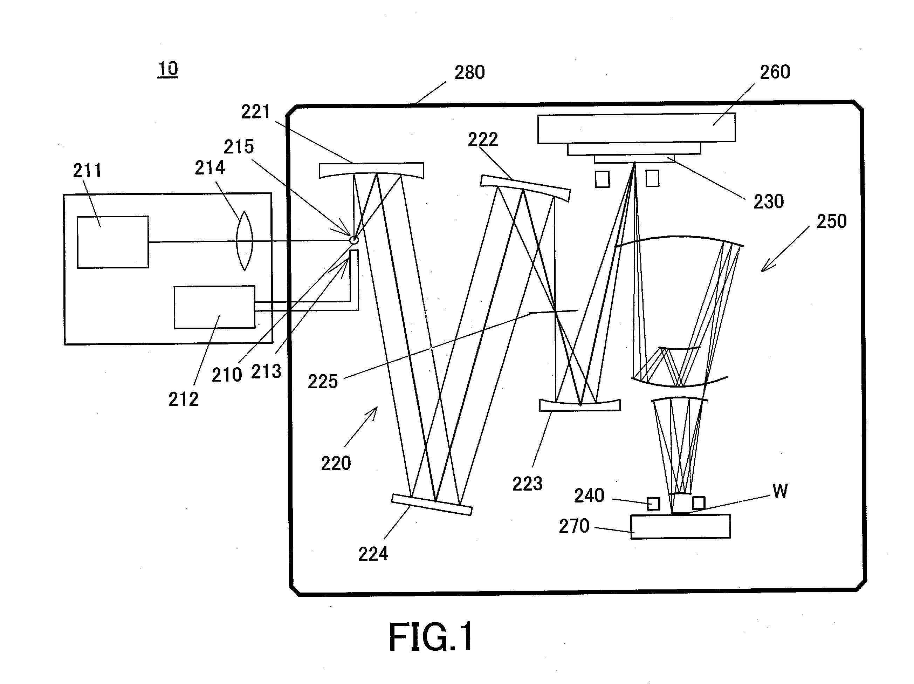

With reference to accompanying drawings, a description will now be given of an exposure apparatus 10 that uses an optical element 100 of one aspect according to the present invention. In each figure, the same reference numeral indicates a corresponding member. Here, FIG. 1 is a typical view showing the exposure apparatus 10 of one aspect of the present invention.

The inventive exposure apparatus 10 uses EUV light with a wavelength of 5 to 20 nm, for example, a wavelength of 13.4 nm as illumination light for exposure. The exposure apparatus 10 forms an arc or ring image surface, and exposes the whole area on the mask by scanning the mask and the wafer at a speed ratio of a reduction ratio. Any other method is applicable. Referring to FIG. 1, the exposure apparatus 10 includes an EUV light source 210 (221 to 229), the optical element 100, an illumination optical system 220, a catoptric reticle 230, an alignment optical system 240, a projection optical system 250, a reticle stage 260, and a wafer stage 270. An optical path through which EUV passes is preferably maintained in a vacuum atmosphere due to low transmittance to air of the EUV light, and thus it is housed in a vacuum chamber 280 that includes a first vacuum chamber 281 and a second vacuum chamber 282 which are connected to each other through a window part 283. The optical element 100 may be combined with and serve as part of the EUV light source 210, or it may be combined with and serve as part of the illumination optical system 220.

The EUV light source 210 of this embodiment employs, for example, a laser plasma light source. The laser plasma light source generates high temperature plasma 215 by irradiating a exciting pulse laser beam 110 generated from a pulse laser (not shown) via a condensing lens 214 onto a target material that is supplied in a vacuum chamber 280 by a target supply unit, which includes, for example, a supply nozzle 130 for jetting droplets as a target material, and an exhausting section 140 for collecting unused droplets. It uses the EUV light with a wavelength of about 13.4 nm as the light source 210, which has been irradiated from the plasma. The target material may use a metallic thin film, an inert gas, a liquid-drop, etc., and the target supply unit may use a gas jet and so on The pulse laser 211 is usually driven with a higher repetitive frequency, such as several kHz, for increased average intensity of radiated EUV. An alternative embodiment may use a discharge plasma light source, which emits gas around an electrode in the vacuum chamber 280, applies pulse voltage to the electrode to cause discharge, generates high temperature plasma, and uses EUV light with a wavelength of, for example, about 13.4 nm radiated from it.

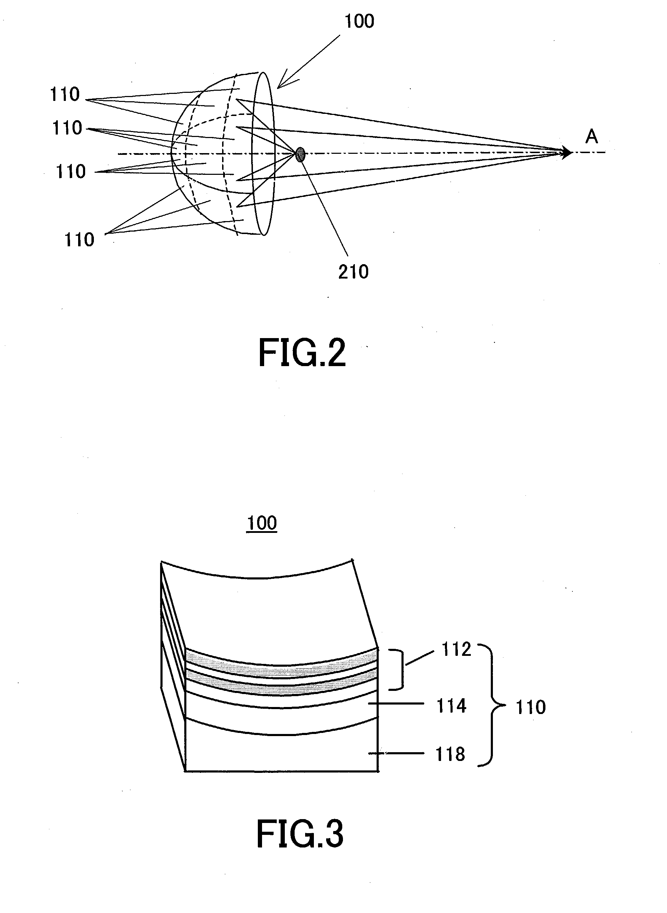

The optical element 100 shown in detail in FIG. 2 is a spheroidal condenser mirror for efficiently utilizing the EUV light irradiated from the light source 210. Here, FIG. 2 is an enlarged typical view around an EUV light source 210 shown in FIG. 1. FIG. 3 is a schematic sectional view showing one mirror 110 in the optical element 100 shown in FIG. 2. The optical element 100 is a first mirror of the illumination optical system 220 made of Mo / Si multilayer in this embodiment (or part of the light source element that irradiates the EUV light source 210), and has a spheroid body to take in more divergent light from the plasma light source. The plasma light source 210 is located at a focal point of the optical element or first mirror 100, which may take in about $2\pi$ str of light. The optical system 100 integrates plural multilayer mirrors 110 that are made divisible along dotted lines in FIG. 2. Each multilayer mirror 110 exemplarily includes, in order from the surface, a multilayer 112, a protective layer (not shown), a release layer 114, and a substrate 118.

The multilayer 112 alternately forms or layers two kinds of materials of different optical constants (e. g., molybdenum (Mo) / silicon (Si)). For example, a molybdenum layer is about 2 nm thick, a silicon layer is about 5 nm thick, and the number of layers is about 20 pairs of layers. A sum of thickness of two kinds of materials is called a coating cycle. In the above example, the coating cycle is 2 nm + 5 nm = 7 nm. A multilayer 112 accumulating about 20 pairs of layers (each thickness of one pair of layers is about 7 nm) exhibits almost 70% of reflectance in the EUV region.

The protective layer (not shown) located below is made of $SiO_2$ with a thickness of 30 nm to 50 nm and used to protect aluminum of the release layer 114. The release layer 114 is made of aluminum with a thickness of 100 nm. The protective layer is not necessarily needed. The substrate 118 is a (ceramic) glass plate fabricated with a good surface precision for reflectance, etc. A curved surface is so precisely polished with surface roughness $\sigma$ = 0.2 nm that the degradation of reflectance may be within 5 % due to the surface roughness when light with a wavelength of about 13 nm enters the multilayer mirror with normal incidence or at $\theta$ = 0°.

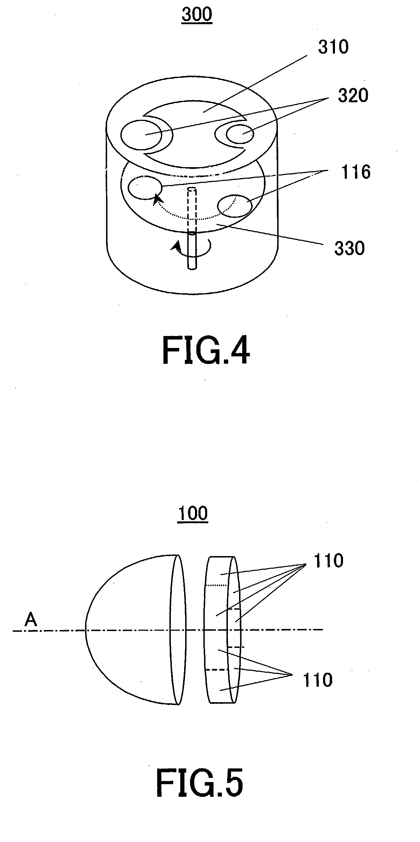

A thickness d of the multilayer 112 satisfies above Equation 1 with the wavelength $\lambda$ of reflected light and incident angle $\theta$. Since the use wavelength for the exposure apparatus 10 is fixed, a film thickness needs to change depending on incident angles $\theta$. The optical element 100 needs to have a film thickness distribution along an axis A that connects focal points of an ellipsoid to each other. A difference in the film thickness distribution becomes large according to having large curvature. The evaporation is a major coating method that evaporates several kinds of materials, rotates the holder 330 that supports the substrate 118, and passes it over the evaporation source 320. FIG. 4 shows a schematic view of an evaporation unit 300. Two evaporation sources 320 are provided to form multilayer of Mo / Si. The unit 300 has a shutter to control a film thickness distribution on the surface. It is thus difficult to provide a surface having a large curvature with a film thickness distribution.

A difference in film thickness distribution which individual mirrors need may be small by dividing the optical element 100 perpendicular to the axis A that connects focal points of an ellipsoid or a line with an equal light incident angle θ. A subdivision into plural pieces, for example, as in a dotted line parallel to the axis A, would realize a flat surface as shown in FIG. 5. Here, FIG. 5 is a typical view showing a subdivision of the optical element shown in FIG. 2. This facilitates coating. An additional advantage is that the evaporation unit 300 may be small because individual mirrors are small. The light that defines an incident angle is one that emitted from a center of a light source (a plasma) with a finite size.

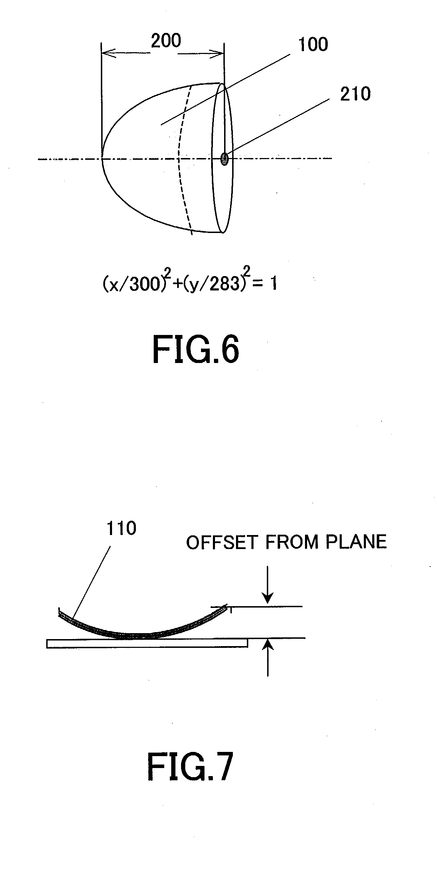

A description will now be given of a spheroidal mirror of a size shown in FIG. 6. When the evaporation unit 300 may coat a substrate of about 100 mm x 100 mm, a mirror is divided at a position of 100 mm from the EUV light source 210 along the axis A that connects focal points to each other (see FIG. 5). As shown in FIG. 7, an offset between the ellipsoid and the flat surface is about 5 mm in a direction orthogonal to the division line. A subdivision of the tubular mirror into 16 pieces provides individual mirrors of about 100 mm x 100 mm. An offset between a circle and the flat surface is about 10 mm. A miniaturized mirror approaches a flat surface, facilitating coating. Here, FIG. 6 is a typical view showing an example of the optical element 100. FIG. 7 is a view showing an offset between a subdivided multilayer mirror 110 and a flat surface.

The EUV light source 210 generates debris and the EUV light from the target 213 and the discharge electrode. Debris sticks to the multilayer 112 or collides with the multilayer 112, destroying its multilayer structure and lowering its reflectance. The mirror reflectance lowers due to deteriorations with time, and contamination of the multilayer 112 by impurities inside a vacuum chamber 280. The first mirror or optical element 100 with deteriorated reflectance should be replaced, but the precisely polished substrate 118 is preferably reused in the multilayer 112.

The instant embodiment removes the multilayer 112 and coats it again, after picking up the optical element 100 and dividing into respective mirrors 110, thereby reusing the substrate 118. Advantageously, a subdivision of plural multilayer mirrors 110 facilitates coating and removal of the multilayer. One exemplary multilayer removal method etches the release layer 114 between the substrate 118 and the multilayer 112, and removes the multilayer 112, as disclosed in "Repair of high performance multilayer coatings", SPIE1547 (1991). This method would increase an area of the release layer 114 to be exposed to a solution as the optical element 100 is divided, and a removal of the multilayer finishes in a shorter time. When the multilayer 112 uses Mo / Si, the release layer 114 uses aluminum with a thickness of 100 nm, the protective layer uses $SiO_2$ with a thickness of 30 nm to 50 nm, and the etchant includes hydrochloric acid and copper sulfate, it takes about four hours to etch the release layer 114 with a diameter of 50 mm without damaging the substrate 118.

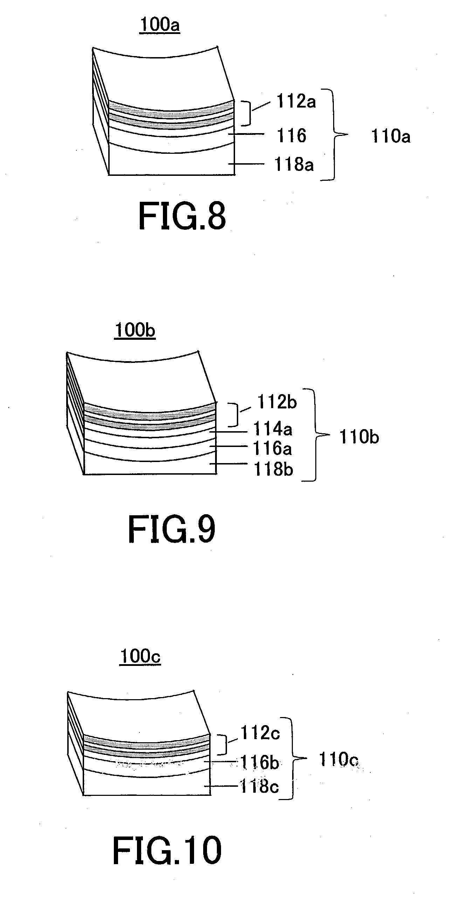

An individual multilayer mirror 110 in the divisible first mirror or optical element 100 in the above embodiment may be a multilayer mirror 110a that includes, as shown in FIG. 8, a substrate 118a, a buffer layer 116, and a multilayer 112a. Here, FIG. 8 is a sectional view corresponding to FIG. 3, which shows an optical element 100a as a variation of the optical element 100. The multilayer 112a is soluble in etchant, but the buffer layer 116 is hard to react with the etchant. It is thus possible to etch only the multilayer 112a with deteriorated reflectance without changing a shape of the substrate 118a. The multilayer 112a is removed once, and formed again on the substrate 118a and the buffer layer 116. Preferably, the etchant is usable at a temperature close to a room temperature in order to avoid the heat deformation of the substrate 118a. A nitric etchant and a TFM type etchant usable at 60 °C are effective for the Mo / Si multilayer 112a. The nitric etchant also influences $SiO_2$ used for the substrate 118a, but this influence is avoidable by a properly selected buffer layer 116. Carbon and ruthenium are effective materials for the buffer layer 116. Ruthenium is comparatively insoluble in base, acid, and agua regia, and thus may be used as a permanent buffer layer. After wet etching removes the multilayer 112a, a dry etching process, *e.g.*, low-temperature plasma ozone etching, selectively removes carbon. While the instant embodiment uses carbon and ruthenium for the buffer layer 116, other materials are applicable if they are insoluble in etchant or if they have a solution velocity of 1/1000 or less of that of the multilayer 112a. For example, suppose 20 pairs of Mo / Si layers and a maximum film thickness distribution of 10% in a mirror. Since a thickness of one layer pair is about 7 nm, a total thickness of the multilayer ranges from about 140 nm to about 154 nm in the thickness distribution, creating a difference in thickness of 14 nm in the mirror. The uniform etching of the multilayer would initially expose part of the buffer layer with a thinner multilayer to etchant. Where the buffer layer has a solution velocity of 1/1000 or less, a change in shape of the buffer layer, after the multilayer is completely removed, may be calculated from a difference in thickness. It is equal to or less than 14nm x 1/1000 = 0.014 nm. This value is sufficiently small and permissible in view of the wavelength of the EUV light.

An individual multilayer mirror 110 in a divisible first mirror or optical element 100 may be a multilayer mirror 110b that includes, as shown in FIG. 9, a substrate 118b, a buffer layer 116a, a release layer 114b, and multilayer 112b. Here, FIG. 9 is a sectional view corresponding to FIG. 3, which shows an optical element 100b as a variation of the optical element 100. The release layer 114a is soluble in etchant, whereas the buffer layer 116a hardly reacts with the etchant.

Germanium, chrome, etc. are effective materials for the release layer 114a. Carbon is suitable for the buffer layer 116a. The release layer 114a made of germanium is quickly etched in a sodium hydroxide solution at room temperature. The release layer 114a made of chrome is etched in a TFM-type etchant. After the release layer 114a is removed, carbon is selectively removed in the dry etching process, *e.g.*, low temperature plasma ozone etching.

An individual multilayer mirror 110 in the divisible first mirror 100 may be a multilayer mirror 110c that includes, as shown in FIG. 10, a substrate 118c, a buffer layer 116b, and a multilayer 112c. Here, FIG. 10 is a sectional view corresponding to FIG. 3, which shows an optical element 100c as a variation of the optical element 100. The multilayer 112c is removed by dry etching, while the buffer layer 116b hardly reacts on the dry etching. Therefore, the dry etching may remove only multilayer 112c with deteriorated reflectance without changing a shape of the substrate 118c. Preferably, the buffer layer is made of a material that is not removed by dry etching or that has a removal velocity of 1/1000 or less of the multilayer.

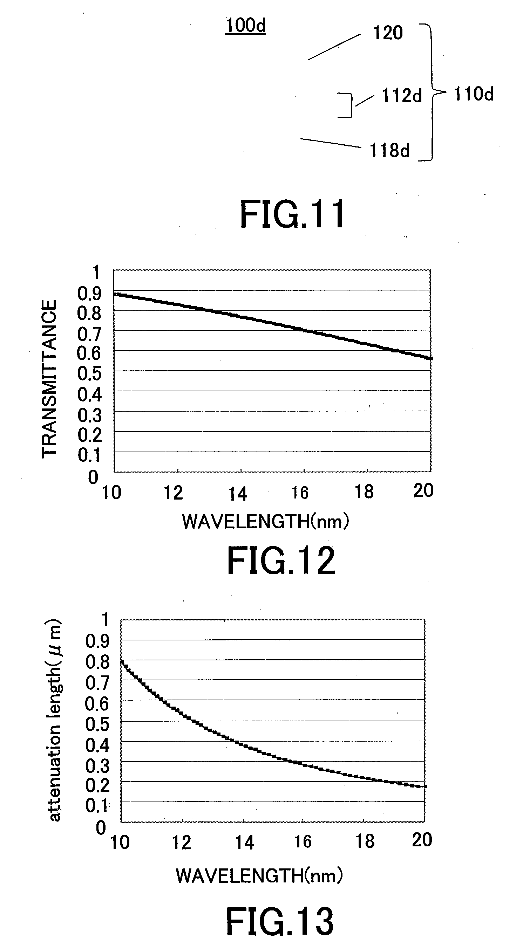

The divisible first mirror or optical element 100 may use a multilayer mirror 110c, as shown in FIG. 11, which includes a protective film 120 made of polyester or acrylic resin transparent to the EUV light, on a top surface of the individual multilayer mirrors 110. Here, FIG. 11 is a sectional view corresponding to FIG. 3, which shows an optical element 100c as a variation of the optical element 100. The protective layer 120 is formed onto the multilayer 112d by spin coating. A subdivision of the mirror 110 into practically flat surfaces would advantageously enable the multilayer 112d to be formed easily and the protective layer 120 to be formed with a thin film with a uniform thickness. Debris generated from the EUV light source 210 and impurities in the vacuum chamber stick to or collide with the surface of the protective layer 120 without damaging the multilayer 112d below it. The protective layer 120 is dissolved an organic or alkaline solvent to dissolve when its reflectance deteriorates, and the protective layer 120 is formed again on the multilayer 112d reusing the multilayer mirror 110d. The miniature multilayer mirror 110d, of course, facilitates dissolving of the protective layer 120. The protective layer 120 is not limited to the above resin, but may use any material if it has transmittance that is sufficiently transparent to the EUV light. A large thickness would lower transmittance, and thus a smaller thickness is desirable if it may protect the multilayer. FIG. 12 is a spectral transmittance of polypropylene having a thickness of 0.1 μm, and FIG. 13 shows an attenuation length of polypropylene. When about 80% of transmittance is needed for a wavelength of 13 nm, a proper thickness of a polypropylene protective layer becomes 0.05 μm.

The illumination optical system 220 propagates the EUV light to illuminate a reticle (mask) 230. The illumination optical system 220 includes, as shown in FIG. 1, mirrors 221, 223, 225, 227, 228 and 229, a catoptric optical integrator 222 and 224, and an aperture 225. The mirror 221 collimates incident EUV light and supplies it to the optical integrator 222. The optical integrator 222 forms plural secondary light sources. The mirror 223 superimposes light from the secondary light sources and supplies it to the optical integrator 224. The optical integrator 224 again forms secondary light sources, and the mirror 225 superimposes light on the aperture 226 to uniformly illuminating the aperture 226. The EUV light from the aperture is relayed to the reticle 230 via the mirrors 227 and 229. The aperture 225 is arranged in a position substantially conjugate with the reticle 230 so as to limit an illuminated area on the reticle 230 surface.

The projection optical system 250 is a catoptric reduction projection optical system including plural mirrors 251 to 256, especially suitable for the EUV light having a wavelength, for example, of 13.4 nm, for reducing and projecting a pattern on the mask 230 onto an object W.

The reticle stage 260 and the wafer stage 270 each include a mechanism for scanning synchronously at a speed ratio in proportion to a reduction ratio. Here, "X" is a scan direction in the reticle 230 surface or the object W surface, "Y" is a direction perpendicular to it, and "Z" is a direction perpendicular to the reticle 230 surface or the object W surface.

The reticle 230 forms a desired pattern and is held on a reticle chuck (not shown) on the reticle stage 260. The reticle stage 260 has a mechanism for moving in the direction X, and a fine adjustment mechanism in the directions X, Y, Z, and rotational directions around each axis for positioning the reticle 230. A position and orientation of the reticle stage 260 are measured by a laser interferometer, and controlled based on the measurement results. While the instant embodiment uses a catoptric reticle for the reticle 230, a transmission type reticle are also usable.

The instant embodiment uses a wafer as the object to be exposed W, but it may include a liquid crystal plate and a wide range of other objects to be exposed. Photoresist is applied onto the object W. A photoresist application step includes a pretreatment, an adhesion accelerator application treatment, a photoresist application treatment, and a pre-bake treatment. The pretreatment includes cleaning, drying, etc. The adhesion accelerator application treatment is a surface reforming process so as to enhance the adhesion between the photoresist and a base (*i.e.*, a process to increase the hydrophobicity by applying a surface active agent), through a coat or vaporous process using an organic film such as HMDS (Hexamethyl-disilazane). The pre-bake treatment is a baking (or burning) step, softer than that after development, which removes the solvent.

An object to be exposed W is held onto the wafer stage 270 by a wafer chuck (not shown). Similar to the reticle stage 260, the wafer stage 270 has a mechanism for moving in the direction X, and a fine adjustment mechanism in the directions X, Y, Z, and rotational directions around each axis for positioning the object W. The position and orientation of the wafer stage 270 are measured by a laser interferometer, and controlled based on the measurement results.

The alignment detection optical system 240 measures a positional relationship between the position of the reticle 230 and the optical axis of the projection optical system 250, and a positional relationship between the position of the object W and the optical axis of the projection optical system 250, and sets positions and angles of the reticle stage 260 and the wafer stage 270 so that a projected image of the reticle 230 may be positioned in place on the object W. A focus detection optical system (not shown) measures a focus position in the direction Z on the object W surface, and control over a position and angle of the wafer stage 270 may always maintain the wafer surface at an imaging position of the projection optical system 250 during exposure.

Once a scan exposure finishes on the object W, the wafer stage 270 moves stepwise in the directions X and Y to the next start position for scan exposure, and the reticle stage 260 and the wafer stage 270 synchronously scan in the direction X at a speed ratio in proportion to the reduction ratio of the projection optical system.

While the reduced projected image of the reticle 230 is formed on the object W, a synchronous scan between them is repeated in a step-and-scan manner. A pattern on the reticle 230 is thus transferred onto the entire area on the object W.

A space in which the EUV light propagates and the optical element for receiving the EUV light is located should be maintained under a certain pressure or lower, in order to prevent gas from absorbing the EUV light, and remnant carbons and other molecules from adhering to the optical element. The light source, the illumination optical system 220, the projection optical system 250, the reticle 230, the object W, etc. are housed in the vacuum chamber 280, which is exhausted of air for a certain degree of vacuum.

In exposure, the illumination optical system 220 uses the EUV light emitted from the EUV light source 210 and condensed by the first mirror or optical element 100 to illuminate the mask 230 and images a pattern on the mask 230 surface onto the object W surface, such as a wafer, to which resist is applied. The present embodiment forms an arc or ring image surface, and exposes the entire area on the mask by scanning the mask and wafer at the speed ratio of the reduction ratio.

While the instant embodiment uses an optical element as one aspect of the present invention for the first mirror 100, the present invention is not limited to this embodiment. The optical element as one aspect of the present invention is applicable to another optical element in the illumination optical system 220 other than the first mirror 100 and an optical element in the projection optical system 250. In this case, a surface shape of the optical element may be formed as a paraboloid of revolution rather than a spheroid.

The exposure apparatus does not limit the light source unit to one in the instant embodiment. The light source unit may use, for example, a Z pinch method as one discharge method, a plasma focus, a capillary discharge, a hollow cathode triggered Z pinch, etc.

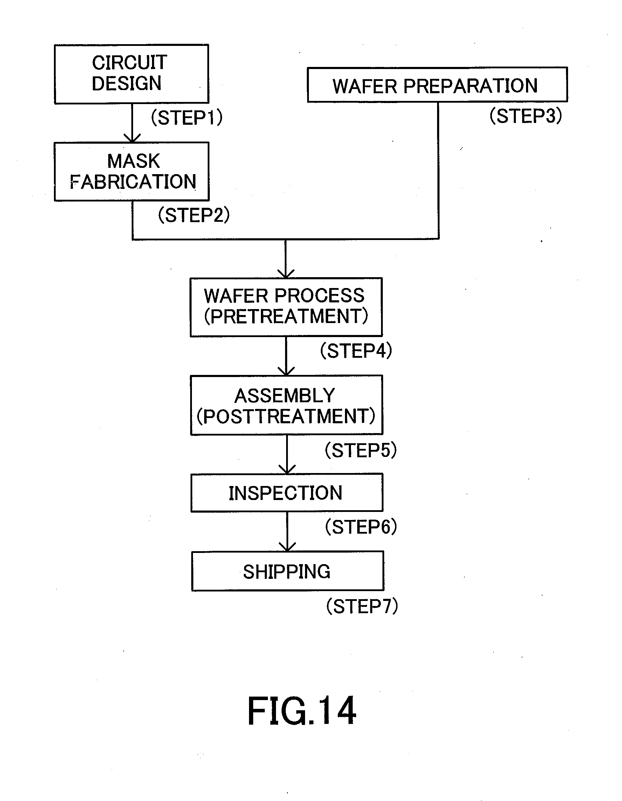

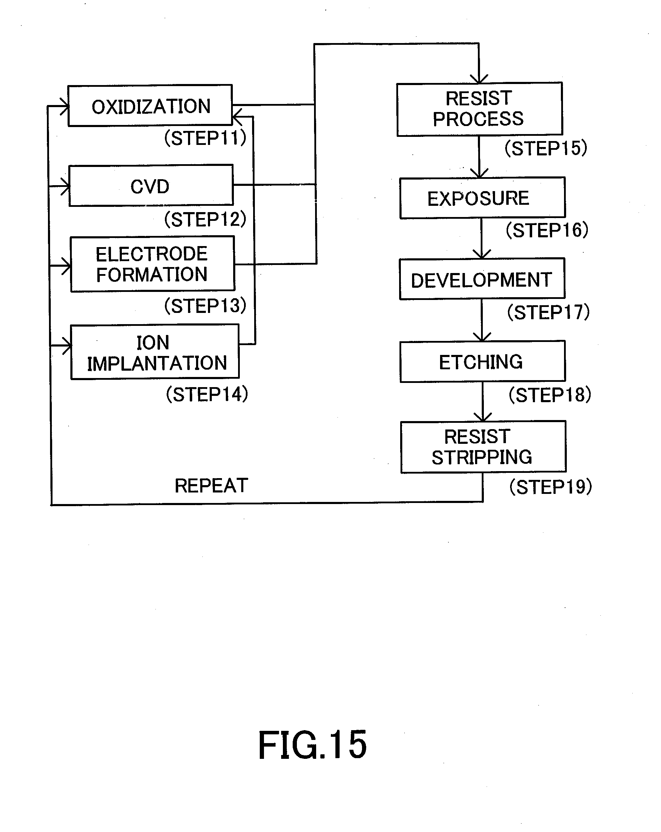

Referring now to FIGs. 14 and 15, a description will be given of an embodiment of a device fabricating method using the above exposure apparatus. FIG. 14 is a flowchart for explaining a fabrication of devices (i. e., semiconductor chips such as IC and LSI, LCDs, CCDs, etc.). Here, a description will be given of a fabrication of a semiconductor chip as an example. Step 1 (circuit design) designs a semiconductor device circuit. Step 2 (mask fabrication) forms a mask having a designed circuit pattern. Step 3 (wafer preparation) manufactures a wafer using materials such as silicon. Step 4 (wafer process), which is referred to as a pretreatment, forms actual circuitry on the wafer through photolithography using the mask and wafer. Step 5 (assembly), which is also referred to as a posttreatment, forms into a semiconductor chip the wafer formed in Step 4 and includes an assembly step (e.g., dicing, bonding), a packaging step (chip sealing), and the like. Step 6 (inspection) performs various tests for the semiconductor device made in Step 5, such as a validity test and a durability test. Through these steps, a semiconductor device is finished and shipped (Step 7).

FIG. 15 is a detailed flowchart of the wafer process in Step 4 in FIG. 14. Step 11 (oxidation) oxidizes the wafer's surface. Step 12 (CVD) forms an insulating film on the wafer's surface. Step 13 (electrode formation) forms electrodes on the wafer by vapor disposition and the like. Step 14 (ion implantation) implants ion into the wafer. Step 15 (resist process) applies a photosensitive material onto the wafer. Step 16 (exposure) uses the exposure apparatus 200 to expose a circuit pattern on the mask onto the wafer. Step 17 (development) develops the exposed wafer. Step 18 (etching) etches parts other than a developed resist image. Step 19 (resist stripping) removes disused resist after etching. These steps are repeated, and multilayer circuit patterns are formed on the wafer.

Further, the present invention is not limited to these preferred embodiments, and various variations and modifications may be made without departing from the scope of the present invention.

The preferred embodiment divides an optical element having a large curvature, and facilitates formations and removals of a multilayer and a protective layering. This allows the multiple coating or the protective layering to be exchanged when the reflectance of the mirror reduces, recovering the reflectance to its initial state.

**Claims**

1. An optical element comprising plural multilayer mirrors, **characterized in that** said multilayer mirrors are renewable.

2. An optical element according to claim 1, **characterized in that** said optical element has a concave shape, and serves to condense incident light.

3. An optical element according to claim 1, **characterized in that** said multilayer mirror has a dividable side along a line having an equal incident light angle to said optical element.

4. An optical element according to claim 1, **characterized in that** said multilayer mirror forms a release layer and a multilayer in this order on a substrate, and the release layer is soluble in a solution that is less reactive with the substrate.

5. An optical element according to claim 4, **characterized in that** the release layer dissolves in the solution at a speed 1000 times or more faster than the substrate.

6. An optical element according to claim 1, **characterized in that** said multilayer mirror forms a buffer layer and a multilayer in this order on a substrate, and the multilayer is soluble in etchant that is less reactive with the buffer layer.

7. An optical element according to claim 6, **characterized in that** the buffer layer dissolves in the etchant at a speed equal to or less than 1/1000 of a solution velocity of the multilayer.

8. An optical element according to claim 1, **characterized in that** said multilayer mirror forms a buffer layer and a multilayer in this order on a substrate, and the multilayer is removable by a dry etching process that is less reactive with the buffer layer.

9. An optical element according to claim 8, **characterized in that** the buffer layer is removed by the dry etching process at a speed equal to or less than 1/1000 of a removal velocity of the multilayer.

10. An optical element according to claim 1, **characterized in that** said multilayer mirror forms a buffer layer, a release layer, and a multilayer in this order on a substrate, and the release layer is soluble in a solution that is less reactive with the buffer layer.

11. An optical element according to claim 10, **characterized in that** the release layer dissolves in the solution at a speed 1000 times or more faster than that of the buffer layer.

12. An optical element according to claim 1, **characterized in that** said multilayer mirror is designed to reflect EUV light.

13. An optical element according to claim 1, **characterized in that** said multilayer mirror comprises a protective layer for protecting said multilayer mirror on a surface of the multilayer mirror.

14. A light source unit **characterized in** comprising:

    an X-ray light source that generates plasma and an X ray; and
    an optical element according to claim 1 for condensing the X ray generated from said X-ray light source.

15. An exposure apparatus **characterized in** comprising:

    an X-ray light source unit that generates plasma and an X ray;
    an illumination optical system that includes an optical element according to claim 1 and uses light that has passed the optical element to illuminate a reticle; and
    a projection optical system for projecting a pattern formed on the reticle onto an object to be exposed.

16. An exposure apparatus **characterized in** comprising:

    a light source unit according to claim 14;
    an illumination optical system that uses light from said light source unit to illuminate a reticle; and
    a projection optical system for projecting a pattern formed on the reticle onto an object to be exposed.

17. A device fabrication method comprising the steps of:

    exposing an object using an exposure apparatus according to claim 15 or 16; and
    performing a predetermined process for the object exposed.

18. A reflective optical element, for reflecting light of a wavelength of 30nm or less, comprising a substrate and a reflective coating comprising a plurality of layers,
    **characterised in that** the plurality of layers are removable without substantial damage to the surface smoothness of the substrate.

19. A reflective optical element according to claim 18 which comprises a plurality of adjacent element portions, each element portion comprising a respective portion of said substrate and a respective portion of said reflective coating.

20. A reflective optical element according to claim 18 or claim 19 which is suitable for reflecting exposure light in apparatus for exposing a substrate with a pattern of light.

FIG.1

FIG.2

FIG.3

300

310

320

116

330

# FIG.4

100

110

A

110

# FIG.5

200    100

210

$$(x/300)^2 + (y/283)^2 = 1$$

# FIG.6

110    OFFSET FROM PLANE

# FIG.7

100a

FIG.8

100b

FIG.9

100c

FIG.10

<u>100d</u>

120

112d ⎫ 110d

118d

# FIG.11

# FIG.12

# FIG.13

CIRCUIT
DESIGN

(STEP1)

WAFER PREPARATION

(STEP3)

MASK
FABRICATION

(STEP2)

WAFER PROCESS
(PRETREATMENT)

(STEP4)

ASSEMBLY
(POSTTREATMENT)

(STEP5)

INSPECTION

(STEP6)

SHIPPING

(STEP7)

# FIG.14

OXIDIZATION

(STEP11)

CVD

(STEP12)

ELECTRODE
FORMATION

(STEP13)

ION
IMPLANTATION

(STEP14)

RESIST
PROCESS

(STEP15)

EXPOSURE

(STEP16)

DEVELOPMENT

(STEP17)

ETCHING

(STEP18)

RESIST
STRIPPING

(STEP19)

REPEAT

# FIG.15

**European Patent Office**

## PARTIAL EUROPEAN SEARCH REPORT

Application Number

which under Rule 45 of the European Patent Convention EP 03 25 2971
shall be considered, for the purposes of subsequent
proceedings, as the European search report

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 607 939 A (WISSENSCHAFTLICH TECH OPTIKZEN) 27 July 1994 (1994-07-27)<br><br>* abstract *<br>* column 1, line 3 - line 5 *<br>* column 1, line 53 - line 57 *<br>* column 2, line 34 - line 42 *<br>* column 4, line 2 - line 50 *<br>* column 6, line 9 - line 10 *<br>* column 6, line 35 - line 41 *<br>--- | 1,2, 4-13, 18-20 | G02B5/08<br>G02B1/10 |
| X | US 6 110 607 A (MONTCALM CLAUDE ET AL) 29 August 2000 (2000-08-29)<br>* column 4, line 12 - line 25; figure 1 *<br>* column 5, line 26 - line 46 *<br>--- | 1,2,4-20 | |
| X | EP 0 987 601 A (NIPPON KOGAKU KK) 22 March 2000 (2000-03-22)<br>* abstract *<br>--- | 15-17 | |
| P,X | EP 1 291 680 A (NIPPON KOGAKU KK) 12 March 2003 (2003-03-12)<br>* abstract *<br>---<br>-/-- | 18 | TECHNICAL FIELDS SEARCHED (Int.Cl.7)<br><br>G02B<br>G03F |

### INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| THE HAGUE | 1 October 2003 | Scheu, M |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C07)

**European Patent Office**

**INCOMPLETE SEARCH
SHEET C**

Application Number

EP 03 25 2971

Claim(s) searched completely:
    1,2,4-20

Claim(s) not searched:
    3

Reason for the limitation of the search:

Claim 3 contains the technical feature "the mirror has a dividable side along a line having equal incident light angle to said optical element". It is not clear how the interrelation between the mirror (being part of the optical element), the optical element itself and the "light angle" is defined by this feature. This leads to a lack of clarity within the meaning of Article 84 EPC to such an extent as to render a meaningful search of the claim impossible. Consequently, the search has been carried out for those parts of the application which do appear to be clear, namely claims 1,2,4-20

**European Patent Office**

**PARTIAL EUROPEAN SEARCH REPORT**

Application Number

EP 03 25 2971

| | DOCUMENTS CONSIDERED TO BE RELEVANT | | CLASSIFICATION OF THE APPLICATION (Int.Cl.7) |
|---|---|---|---|
| Category | Citation of document with indication, where appropriate, of relevant passages | Relevant to claim | |
| X | EP 1 174 770 A (ASM LITHOGRAPHY BV) 23 January 2002 (2002-01-23) * abstract; claim 21; figures 1-3 * --- | 1,14-17 | |
| P,X | US 2003/043483 A1 (FOLTA JAMES A ET AL) 6 March 2003 (2003-03-06) * paragraphs '0010!,'0013!-'0015!,'0023!,'0024!,'0026!; claims 1-4,7,16-18 * ----- | 1,2, 4-13, 18-20 | |
| | | | **TECHNICAL FIELDS SEARCHED** (Int.Cl.7) |

EPO FORM 1503 03.82 (P04C10)

**ANNEX TO THE EUROPEAN SEARCH REPORT
ON EUROPEAN PATENT APPLICATION NO.**                EP 03 25 2971

This annex lists the patent family members relating to the patent documents cited in the above-mentioned European search report.
The members are as contained in the European Patent Office EDP file on
The European Patent Office is in no way liable for these particulars which are merely given for the purpose of information.

01-10-2003

| Patent document cited in search report | | Publication date | Patent family member(s) | | Publication date |
|---|---|---|---|---|---|
| EP 0607939 | A | 27-07-1994 | DE | 4301463 A1 | 21-07-1994 |
| | | | DE | 59405815 D1 | 04-06-1998 |
| | | | EP | 0607939 A1 | 27-07-1994 |
| US 6110607 | A | 29-08-2000 | AU | 3297799 A | 06-09-1999 |
| | | | WO | 9942414 A1 | 26-08-1999 |
| | | | US | 6309705 B1 | 30-10-2001 |
| EP 0987601 | A | 22-03-2000 | JP | 2000100685 A | 07-04-2000 |
| | | | EP | 0987601 A2 | 22-03-2000 |
| EP 1291680 | A | 12-03-2003 | JP | 2003066195 A | 05-03-2003 |
| | | | JP | 2003077805 A | 14-03-2003 |
| | | | JP | 2003075591 A | 12-03-2003 |
| | | | JP | 2003084094 A | 19-03-2003 |
| | | | JP | 2003084095 A | 19-03-2003 |
| | | | EP | 1291680 A2 | 12-03-2003 |
| | | | US | 2003081722 A1 | 01-05-2003 |
| EP 1174770 | A | 23-01-2002 | EP | 1174770 A2 | 23-01-2002 |
| | | | JP | 2002083767 A | 22-03-2002 |
| | | | US | 2002011573 A1 | 31-01-2002 |
| US 2003043483 | A1 | 06-03-2003 | NONE | | |

EPO FORM P0459